(19) **Europäisches Patentamt**

**European Patent Office**

**Office européen des brevets**

(11) **EP 1 396 931 A1**

(12) **EUROPEAN PATENT APPLICATION**

(43) Date of publication:
**10.03.2004 Bulletin 2004/11**

(51) Int Cl.⁷: **H03C 1/00**

(21) Application number: **02292047.4**

(22) Date of filing: **16.08.2002**

| | |
|---|---|
| (84) Designated Contracting States:<br>**AT BE BG CH CY CZ DE DK EE ES FI FR GB GR<br>IE IT LI LU MC NL PT SE SK TR**<br>Designated Extension States:<br>**AL LT LV MK RO SI** | • **Chin, Yuan Fuat<br>Singapore 679645 (SG)**<br><br>(74) Representative: **Rossmanith, Manfred, Dr. et al<br>Deutsche Thomson-Brandt GmbH<br>European Patent Operations<br>Karl-Wiechert-Allee 74<br>30625 Hannover (DE)** |
| (71) Applicant: **Thomson Licensing S.A.<br>92648 Boulogne Cedex (FR)** | |
| (72) Inventors:<br>• **Li, Chun Fat<br>Singapore 529861 (SG)** | |

(54) **Modulator and transmitter for IR codes and method**

(57)  A device and method for emitting amplitude-modulated signals, which are fed to an emitting member from a signal source via a driver stage, said amplitude-modulated signals containing a higher frequency carrier and a lower frequency useful signal modulated onto said carrier, said device comprises amplifying means for amplifying the level of the signals received from the signal source to a predetermined level. The device further comprises integrating means for performing integration on the amplified signals so as to remove the higher frequency carrier and signal regenerating means for regenerating the useful signal from the integrated signals and providing the useful signal to said driver stage and emitting member for emission. The high frequency carrier can be removed effectively from the modulated IR signals from the signal source.

**Fig. 3**

## Description

The present invention relates to a device and method for selectively demodulating IR codes, which is a digital approach for removing high frequency carrier from IR codes.

Common IR remote control codes are modulated onto a low frequency carrier in the range 20 - 40 kHz. Due to limitations in some ICs generating the IR codes, certain IR codes are modulated onto a high frequency carrier, e.g. 20MHz, during creation. However, not all codes will be modulated onto the high frequency carrier. In these cases, the IR codes are generated as is by the IC. The high frequency carrier must be removed from the modulated IR codes before they are transmitted, because the carrier is not part of the IR codes, while the low frequency carriers must be maintained.

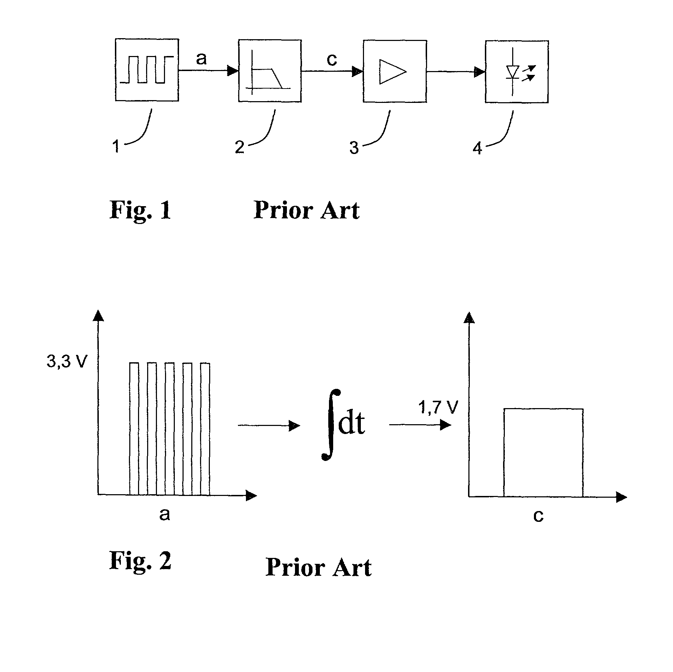

Fig. 1 illustrates a general structure of a known solution for removing the high frequency carrier. As is shown in Fig. 1, IR codes modulated onto a high frequency carrier from signal source 1 are transmitted to a trap unit 2. The trap unit 2 will remove the high frequency carrier and the remaining signal at the output of the unit 2 contains the IR codes modulated onto the low frequency carrier only. The driver unit 3, upon receiving the IR codes from the trap unit 2, drives the IR LED unit 4. The trap unit 2 is an analog low pass filter and has characteristics, which may affect the actual IR codes.

The waveforms of the signals from the signal source 1 and the signals after integration at the output of the integrator unit 2 are shown in the illustration of prior art in Fig. 2. As is shown in Fig. 2, the signal source issues a signal (a) at a level of 3.3 V, having a duty cycle of 50%. The signal level after integration (c) is only about half as high as the signal level of the source. It is to be noted that the absolute ratio of input and output level of the integrator varies with the duty cycle. In the example, the signal level after integration is approximately 1.7V. Since the driver unit 3 may use TTL logic levels for operation, the signal may not be detected correctly. TTL level signals typically range from 0 - 0.8 V for logical 0, and >2 V for logical 1. Thus, the level of the output signal of the integrator lies within the undetermined transition area of TTL level signals.

Since digital circuits have inherent predictable properties over time and wide ranging temperature, it is desired to provide a digital approach for removing the high frequency carrier from the low frequency IR codes, which overcomes the drawbacks of the analog filter circuits of the prior art.

The object of the invention is to provide a digital approach for removing the high frequency carrier from the low frequency IR codes by taking advantage of the inherent predictable properties of digital circuits over time and wide temperature range.

To achieve the above-stated object the present invention provides a device for emitting amplitude-modulated signals, which are fed to an emitting member from a signal source via a driver stage, said amplitude-modulated signals containing a higher frequency carrier and a lower frequency useful signal modulated onto said high frequency carrier, said device comprising: amplifying means for amplifying the level of the signals received from the signal source to a predetermined level; integrating means for performing integration on the amplified signals so as to block the higher frequency carrier; and signal regenerating means for regenerating the useful signal from the integrated signals and providing the useful signal to said driver stage and emitting member for emission.

The present invention further provides a method for emitting amplitude-modulated signals, which are fed to an emitting member from a signal source via a driver stage, said amplitude-modulated signals containing a higher frequency carrier and a lower frequency useful signal modulated onto said carrier, said method comprising the steps of: amplifying the level of the signals received from the signal source to a predetermined level; performing integration on the amplified signals so as to remove the higher frequency carrier; and regenerating the useful signal from the integrated signals and providing the useful signal to said driver stage and emitting member for emission.

The forgoing and other objects, aspects and advantages will be better understood from the following detailed description of preferred embodiments of the invention with reference to the drawings, in which:

Fig. 1 illustrates a general structure of a known analog solution for removing the high frequency carrier.
Fig. 2 schematically illustrates the waveforms of the signal generated from the signal source 1 and the signal produced at the output of the trap 2 of Fig. 1.
Fig. 3 illustrates a block diagram of the circuit for removing high frequency carrier from IR codes according to the present invention.
Fig. 4 schematically illustrates the waveforms of the signal generated from the signal source 1 after passing the level shifter and the signal produced at the output of the integrator 2 of Fig. 3.
Fig. 5 shows a detailed circuit diagram according to one embodiment of the present invention.

In the drawings, similar or corresponding parts have identical reference designators.

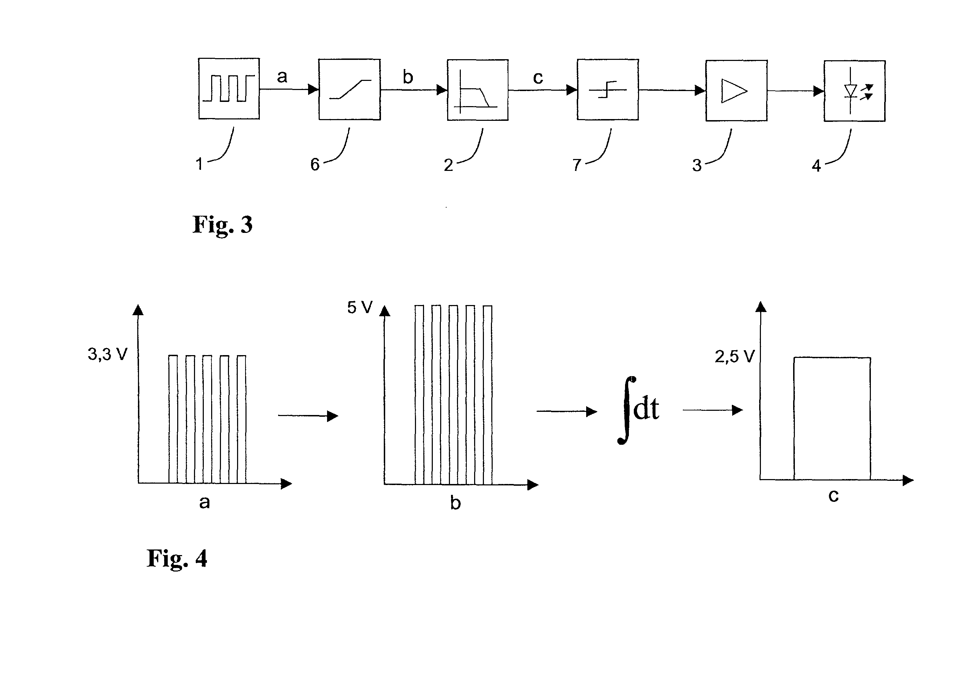

Fig. 3 illustrates a block diagram of the circuit for removing high frequency carrier from low frequency IR codes according to the present invention. As is shown in Fig. 3, between a signal source 1 and a driver stage 3, a level shifter unit 6, an integrator unit 2 and a comparator unit 7 replace the trap unit 2 of the prior art in Fig. 1. The signal source issues an IR code signal modulated onto a high frequency carrier, e.g., 20 MHz. The level shifter unit 6 is used to shift the level of the coded signal from the low level signal source 1 into a high level, e.g., 5 V TTL logic level. The integrator unit 2 at the output of the level shifter unit 6 performs an integration on the amplified signals from the level shifter unit 6. In doing so, the high frequency carrier is removed, but the low frequency IR code signal is not affected, which is the useful signal in the signals from the signal source 1. The integration reduces the maximum level of the signal at the output of the integrator and slightly affects the slope of the signal in the transition phases from low to high and vice versa. The deformation of the signal is not shown in the drawing fro the sake of clarity. However, the level is still high enough to, for example, exceed the switching thresholds of, e.g., TTL signals. The comparator unit 7 acts as a signal regenerator and may be made up from a TTL logic buffer.

The integrator unit 2 is designed to integrate the high frequency pulses but not the low frequency IR code signals. As the frequency of the high frequency carrier (e.g. 20MHz) and the frequency of low frequency carrier of the IR codes (e.g. 20KHz -40KHz) are about ten octaves apart, a simple RC circuit can be used with the time constant chosen to be much higher than the low frequency carrier, for example, 10 times as high as the low frequency carrier. Said time constant of the RC circuit is selected long enough to integrate the 20MHz high frequency carrier. Therefore, the 20MHZ high frequency carrier will be substantially removed from the signals after integration.

The comparator unit 7 at the integrator output is triggered by the low frequency output signal of the integrator. By switching at a certain threshold level, the signal at the output of the comparator unit 7 is reshaped to the desired IR code. The pulse train forming the IR code is then fed to the driver 3 and is transmitted via an emitting member 4.

Fig. 4 illustrates schematically the different signals on their way from the source 1 to the driver 3 with reference to Fig. 3. The signal (a) issued by the source 1 at a level of 3.3 V is level shifted in the level shifter 6 to a signal (b) having a level of 5 V. The integrator integrates the signal (b) and removes the high frequency carrier. Signal (c) at the output of the integrator has a level of 2.5 V, which is high enough to safely trigger the TTL level comparator 3.

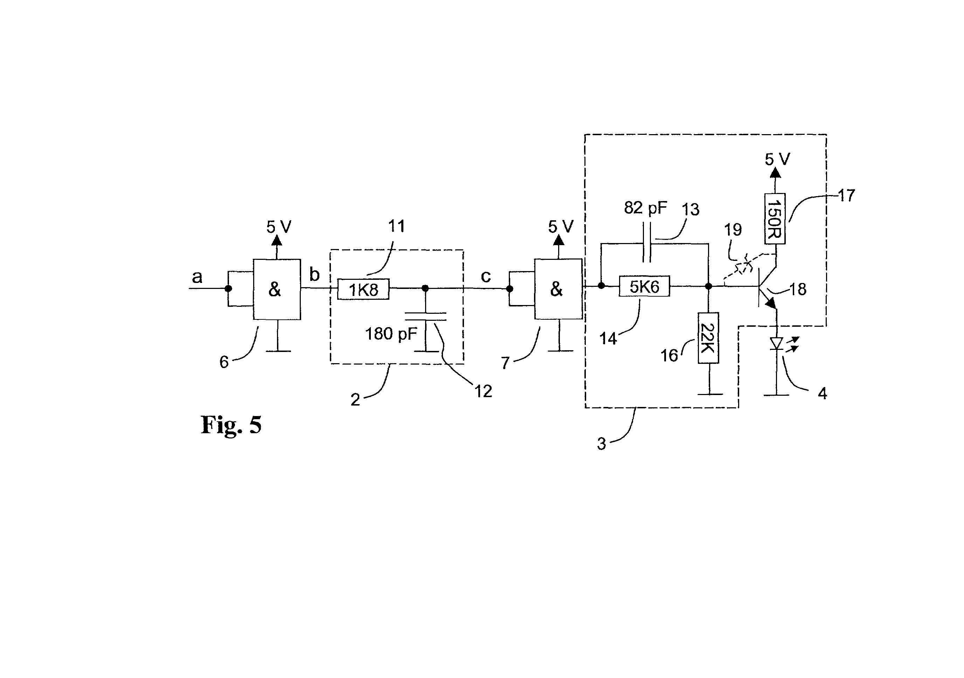

Fig. 5 shows a detailed circuit diagram according to a preferred embodiment of the present invention. As is shown in Fig. 5, a first TTL-logic AND-gate 6 receives a high frequency modulated signal from a low voltage signal source (not shown). The signal source is assumed to supply pulses having an amplitude of 3.3V. The AND-gate 6 is used to transform the 3.3V pulses (a) from the source 1 to 5V TTL pulses (b). An RC integrator 2 comprises a resistor 11 and a capacitor 12. The output of the AND-gate 6 is connected to the resistor 11 of integrator 2. The integrated signals (c) are fed to a second AND-gate 7, which acts as a comparator. The second AND-gate delivers at its output 5V TTL logic pulses, which are substantially the useful signals. The pulses are fed to a driver stage 3. The driver stage 3 comprises a capacitor 13, resistors 14, 16 and 17 and a transistor 18. Resistors 14 and 16 act as a voltage divider. Capacitors 13 bypasses resistor 14 to the base of transistor 18 for fast rise and fall characteristics. Transistor 18 drives an IR LED 4 for emitting the IR codes.

Assuming the high frequency carrier is 20 MHZ and the time constant of the RC circuit integrator 2 is corresponding to 0.5MHz, the parameters of the circuit components can be calculated as follows:

For the integrator: $\tau \Rightarrow 2 * \pi * (0.5\text{MHz}) = 1 / RC$

Assume $R = 1.8\text{K}\Omega$, $C \cong 180\text{pF}$

For the driver transistor:

If the forward voltage of the LED $V_{LED}$ is 1.6V, the required voltage at the collector of transistor 18 is $Vc \cong 1.6\text{V} + 0.2\text{V} = 1.8\text{V}$ (assuming 0.2V for a saturated collector-emitter path).

The Current needed is $I_{LED} = I_E \cong Ic = 20\text{mA}$ (assuming that the emitter and the collector currents substantially equal the current through LED 4). The resistor 17 therefore calculates to

$$Rc \cong (5 - 1.8)\text{V} / 20\text{mA} \cong 150\Omega.$$

If the forward current amplification $\beta$min of the transistor equals 200, the base current calculates to

$$I_B = 4 * Ic / \beta\text{min} = (4 * 20\text{mA}) / 200 = 0.4\text{mA}.$$

The base voltage calculates to $V_B = 1.6\text{V} + 0.65\text{V} = 2.25\text{V}$ (assuming a base-emitter forward voltage of 0.65V).

The current deviated to ground through resistor 16 is $I_{RB2} = 0.1\text{mA}$ $(25\%I_B)$.

Therefore, resistor 14 calculates to

$R_{B1} = (5 - 2.25)\text{V} / 0.5\text{mA} \cong 5.6\text{K}\Omega$, and resistor 16 calculates to $R_{B2} = 2.25\text{V} / 0.1\text{mA} \cong 22\text{K}\Omega$

According to a preferred embodiment of the present invention, a Schottky diode 19 (illustrated in dashed lines in Fig. 5) is connected across the base and collector of the transistor to decrease the turn-off time of the transistor by preventing the saturation of transistor 18.

It can be seen that according to the present invention the high frequency carrier can be removed effectively from the modulated signals from the signal source and the driver stage and the LED transmit the IR codes only. The digital logic circuits used in the present invention advantageously ensure predictable properties over time and wide temperature range.

Having described and illustrated the principles of the invention in the preferred embodiments thereof, it should be apparent that the invention could be modified in arrangement and detail, without departing from the spirit and scope of the invention.

**Claims**

1. A device for emitting amplitude-modulated signals, which are fed to an emitting member from a signal source via a driver stage, said amplitude-modulated signals containing a higher frequency carrier and a lower frequency useful signal modulated by said carrier, **characterized in that**, said device comprises amplifying means for amplifying the level of the signals received from the signal source to a predetermined level; integrating means for performing integration on the amplified signals so as to remove the higher frequency carrier; and signal regenerating means for regenerating the useful signal from the integrated signals and providing the useful signal to said driver stage and emitting member for emission.

2. The device according to claim 1, **characterized in that** said emitting member comprises a LED.

3. The device according to claim 1, **characterized in that** the useful signal comprises IR codes.

4. The device according to claim 1, **characterized in that** said integrating means comprises a RC circuit, and the time constant of the RC circuit is set to be longer than the period of the higher frequency carrier and shorter than the period of the lower frequency useful signal, so that the higher frequency carrier will be removed and the lower frequency useful signal will not be removed.

5. The device according to claim 1, **characterized in that** said amplifying means comprises a TTL gate.

6. The device according to claim 1, **characterized in that** said signal regenerating means comprises a TTL gate.

7. A method for emitting amplitude-modulated signals, which are fed to an emitting member from a signal source via a driver stage, said amplitude-modulated signals containing a higher frequency carrier and a lower frequency useful signal modulated by said carrier, **characterized in that**, said method comprises the steps of amplifying the level of the signals received from the signal source to a predetermined level; performing an integration on the amplified signals so as to block the higher frequency carrier; and regenerating the useful signal from the integrated signals and providing the useful signal to said driver stage and emitting member for emission.

8. The method according to claim 7 **characterized in that** said emitting member comprises a LED.

9. The method according to claim 7 **characterized in that** the useful signal comprises IR codes.

10. The method according to claim 7, **characterized in that** said integrating step is performed by a RC circuit, and the time constant of the RC circuit is set to be longer than the period of the higher frequency carrier and shorter than the period of the lower frequency useful signal, so that the higher frequency carrier is removed and the lower frequency useful signal is not removed.

**Fig. 1**     **Prior Art**

**Fig. 2**     **Prior Art**

**Fig. 3**

**Fig. 4**

$\int dt$

2,5 V

5 V

3,3 V

a  b  c

EP 1 396 931 A1

**Fig. 5**

**European Patent Office**

**EUROPEAN SEARCH REPORT**

Application Number

EP 02 29 2047

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 828 476 A (R. BONEBRIGHT) 27 October 1998 (1998-10-27) * column 3, line 1 - line 49; figure 1 * --- | 1-10 | H03C1/00 |
| A | US 5 786 921 A (L. WANG) 28 July 1998 (1998-07-28) * column 1, line 16 - line 60; figures 5,11 * * column 9, line 36 - line 55; figure 3 * --- | 1-10 | |
| A | US 5 838 475 A (R. TAKEYARI) 17 November 1998 (1998-11-17) * column 4, line 5 - line 34; figure 5 * --- | 1-10 | |
| A | US 5 850 303 A (H. YAMAMOTO) 15 December 1998 (1998-12-15) * column 13, line 16 - column 14, line 19; figure 1 * ----- | 1-10 | |
| | | | TECHNICAL FIELDS SEARCHED (Int.Cl.7) H03C H04B H04L |

The present search report has been drawn up for all claims

| Place of search | Date of completion of the search | Examiner |
|---|---|---|
| THE HAGUE | 6 February 2003 | Butler, N |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 396 931 A1**

## ANNEX TO THE EUROPEAN SEARCH REPORT
## ON EUROPEAN PATENT APPLICATION NO.

EP 02 29 2047

This annex lists the patent family members relating to the patent documents cited in the above-mentioned European search report.
The members are as contained in the European Patent Office EDP file on
The European Patent Office is in no way liable for these particulars which are merely given for the purpose of information.

06-02-2003

| Patent document cited in search report | | | Publication date | | Patent family member(s) | | Publication date |
|---|---|---|---|---|---|---|---|
| US 5828476 | A | | 27-10-1998 | AU<br>WO | 4733997<br>9750199 | A<br>A2 | 14-01-1998<br>31-12-1997 |
| US 5786921 | A | | 28-07-1998 | US<br>EP<br>JP<br>WO | 5617236<br>0776553<br>10504433<br>9605666 | A<br>A1<br>T<br>A1 | 01-04-1997<br>04-06-1997<br>28-04-1998<br>22-02-1996 |
| US 5838475 | A | | 17-11-1998 | JP<br>CA<br>DE<br>EP<br>US | 7221704<br>2141351<br>69527320<br>0666658<br>5576876 | A<br>A1<br>D1<br>A1<br>A | 18-08-1995<br>08-08-1995<br>14-08-2002<br>09-08-1995<br>19-11-1996 |
| US 5850303 | A | | 15-12-1998 | JP<br>JP | 10065618<br>10150432 | A<br>A | 06-03-1998<br>02-06-1998 |

EPO FORM P0459

For more details about this annex : see Official Journal of the European Patent Office, No. 12/82

9